# FASCICULE DE BREVET EUROPEEN

(11) **EP 1 576 722 B1**
(45) Date de publication et mention de la délivrance du brevet: **07.06.2006**
(21) Numéro de dépôt: 03799566.9
(22) Date de dépôt: 15.12.2003
(51) Int. Cl.: H03C 5/00

(54) **PROCEDE DE CORRECTION ET BOUCLE DE CORRECTION D'UN SIGNAL NUMERIQUE COMPLEXE**
KORREKTURVERFAHREN UND KORREKTURSCHLEIFE FÜR EIN KOMPLEXESDIGITALSIGNAL
CORRECTION METHOD AND CORRECTION LOOP FOR A COMPLEX DIGITAL SIGNAL

(30) Priorité: 17.12.2002 FR 0216006
(43) Date de publication de la demande: 21.09.2005
(73) Titulaire: Thales, 92200 Neuilly Sur Seine (FR)
(72) Inventeur: CLOTTEAU, Bruno, c/o Thales Intellectual Property, 94117 CX Arcueil (FR)
(74) Mandataire: Lucas, Laurent Jacques
(86) Numéro de dépôt international: PCT/EP2003/051002
(87) Numéro de publication internationale: WO 2004/055969

(56) Documents cités:
- US-A- 4 194 154
- US-A- 5 249 201
- US-A- 5 838 210
- US-B1- 6 449 465

## Description

L'invention concerne la correction du retard entre la phase et l'enveloppe d'un signal numérique. En particulier, elle concerne l'application de cette correction dans des émetteurs de diffusion numérique.

Le brevet US 4 688 225 propose un système de transmission d'un signal complexe comportant une composante de signal de transmission de données et une composante de signal de diffusion AM. Les émetteurs utilisant la méthode de Kahn, notamment, celui décrit par le brevet US,488,255 pour l'émission d'un signal de diffusion AM, comporte des moyens de traitement séparés de l'enveloppe et de la phase et un multiplicateur du signal d'enveloppe et du signal de phase en sortie.

En modulation numérique, la voie de phase n'est pas comme en AM une fréquence RF pure mais une fréquence RF modulée en phase. Comme le signal d'enveloppe et le signal de phase sont traités par des moyens différents et indépendants, le retard entre ces deux signaux d'enveloppe et de phase doit être ajusté précisément afin d'obtenir un signal RF de sortie de haute qualité.

Une boucle permet un rattrapage automatique et le réglage dynamique du retard entre le signal d'enveloppe et le signal de phase.

La technique généralement utilisée dans les boucles est de comparer dans le domaine temporel le signal initial en bande de base avec le signal RF émis démodulé. Pour cela, le retard entre les deux signaux initial et émis démodulé est évalué précisément. Puis, les parties enveloppe et phase, en mode numérique, des deux signaux initial et émis démodulé sont comparer pour déterminer le retard entre enveloppe et phase.

La présente invention permet d'offrir une solution alternative dans laquelle l'utilisation du signal initial n'est pas nécessaire. Aucune comparaison temporelle avec le signal initial n'est nécessaire.

Un objet de l'invention est un procédé de correction d'au moins un paramètre à corriger pc de l'enveloppe d'un signal numérique comme défini dans la revendication 1.

Un autre objet de l'invention est une boucle de correction d'au moins un paramètre à corriger de l'enveloppe d'un signal numérique comme défini dans la revendication 2

Suivant la variante de l'invention, les paramètres à corriger sont un retard et/ou un offset du signal d'enveloppe par rapport au signal de phase du signal numérique, et/ou une non-linéarité du signal d'enveloppe, et les correcteurs sont, respectivement, un retard inverse et/ou un offset inverse et/ou une pré-correction.

L'invention propose aussi un émetteur comportant un modulateur et la boucle de correction comportant l'entrée recevant un signal numérique modulé, un démodulateur entre l'entrée et le système de calcul, et le dispositif de correction destiné à être implémenté dans un modulateur auquel le démodulateur est associé.

Dans une première variante de l'émetteur selon l'invention, l'émetteur est un émetteur linéaire.

Dans une deuxième variante de l'émetteur selon l'invention, l'émetteur comporte des moyens de décomposition du signal numérique démodulé en un signal d'enveloppe et un signal de phase, en particulier en mettant en oeuvre la méthode de Kahn. des moyens de traitement séparés de la phase et de l'enveloppe du signal numérique modulé.

Les caractéristiques et avantages de l'invention apparaîtront plus clairement à la lecture de la description, faite à titre d'exemple, et des figures s'y rapportant qui représentent :
- Figure 1, émetteur avec boucle de correction du retard entre l'enveloppe et la phase selon l'état de l'art,
- Figure 2a et Figure 2b, représentations schématiques du critère de détermination du correcteur selon l'invention, la figure 2a illustrant la détermination du minimum de la puissance du bruit hors bande et la figure 2b, la notion de critère d'optimisation des épaules du spectre,
- Figure 3, un exemple de schéma bloc du procédé de correction selon l'invention,
- Figure 4, un exemple de boucle de correction selon l'invention,
- Figure 5, un exemple d'émetteur utilisant la méthode de Kahn et comportant la boucle de correction selon l'invention,
- Figure 6, un exemple d'émetteur linéaire comportant la boucle de correction selon l'invention.

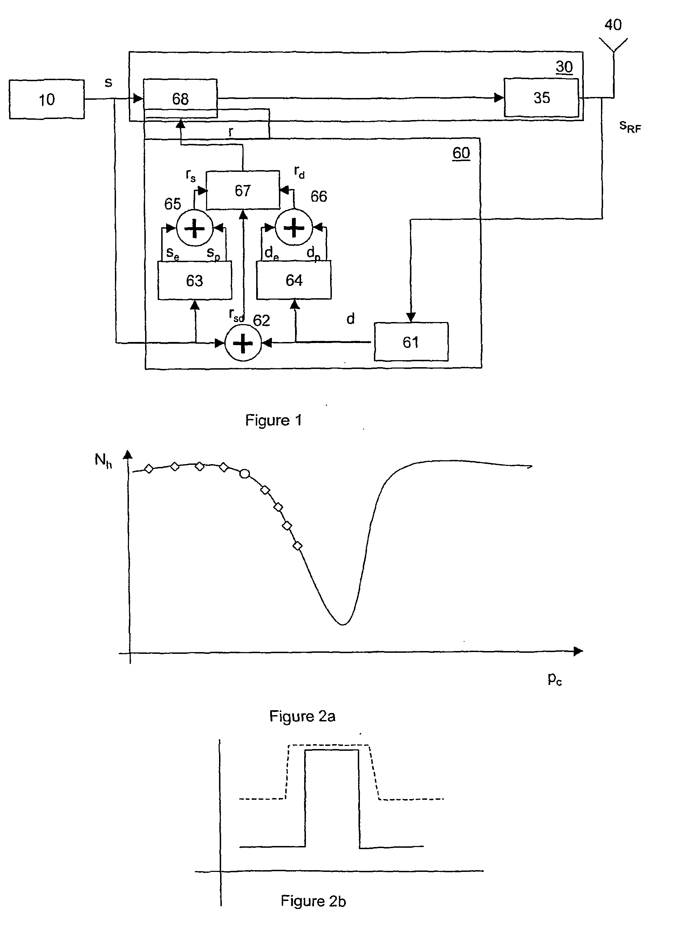

La figure 1 montre un émetteur mettant en oeuvre la technique généralement utilisé dans les boucles 60. Le dispositif de traitement du signal fournit le signal en bande de base au dispositif d'émission 30 qui l'émet sous forme d'un signal radio fréquence (RF) S_{RF} via une antenne 40. Le retard entre l'enveloppe e et la phase p est corriger à l'aide de la boucle de correction 60.

La boucle de correction 60 comporte un démodulateur 61 associé au modulateur 30. Le démodulateur 61 reçoit le signal tel qu'il sera émis, c'est-à-dire le signal RF S_{RF}, et fournit le signal démodulé d. Le signal RF émis démodulé d est comparé au signal en bande de base s dans le domaine temporel par le dispositif de comparaison 62 afin d'évaluer préciser le retard r_{sd} entre les deux signaux RF émis démodulé d et en bande de base s.

Ensuite, les deux dispositifs de décomposition 63 et 64 séparent, respectivement, les deux signaux RF émis démodulé d et en bande de base s en leurs parties enveloppes et phases (en mode numérique) (dₑ, dₚ) et (sₑ, sₚ). Le dispositif de comparaison 65, respectivement le dispositif de comparaison 66, détermine le retard rₛ entre les parties enveloppe et phase (sₑ, sₚ) du signal en bande de base s, respectivement le retard r_{d} entre les parties enveloppe et phase (dₑ, dₚ) du signal RF émis démodulé d.

Le dispositif de traitement 67 reçoit l'ensemble de ses retards r_{sd}, rₛ et r_{d} afin de déterminer le plus précisément possible le retard r permettant au dispositif 68 d'effectuer la correction du retard entre l'enveloppe e et la phase p au sein du modulateur 30. Le modulateur 35 transpose alors le signal en bande de base s en signal RF S_{RF}.

Cette boucle de correction 60 permet un rattrapage automatique et le réglage dynamique du retard entre la voie d'enveloppe e et la voie de phase p.

L'invention propose de déterminer le retard entre l'enveloppe e et la phase p à l'aide d'un autre critère tel que la boucle de correction 60 n'ai pas besoin du signal en bande de base s pour effectuer cette détermination. Ce critère peut en outre s'appliquer à la correction d'autres paramètres p_{c} de l'enveloppe e du signal, notamment à l'offset entre l'enveloppe e et la phase p ou à une non-linéarité de l'enveloppe e définie par ses paramètres [a₀, a₁...aₙ]. L'invention propose donc de manière générale de déterminer le correcteur c, quel que soit le type de paramètre à corriger pc.

La détermination du correcteur est illustré par la figure 2a. La détermination du correcteur se fait par recherche du minimum de la puissance du bruit hors bande Nₕ du signal, émis ramené en bande de base le cas échéant, d=I+jQ=eₑᵣe^{jpₑᵣ} où eₑᵣ=√I²+Q² et pₑᵣ =(I+*j*Q)/eₑᵣ.

Suivant que l'on recherche uniquement à déterminer le correcteur du retard ou de l'offset, ou le correcteur de plusieurs paramètres à corriger tels que le retard et/ou l'offset et/ou les paramètres [a₀, a₁...aₙ] de la non-linéarité, l'on recherche le minimum d'une fonction à une ou plusieurs variables, par exemple Nₕ = f₁(retard), Nh = f2(offset), Nh = f3 (retard, offset), Nh = f4(a₀, a₁...aₙ), etc. La détermination de ce minimum d'une fonction se fait en utilisant les outils mathématiques existants.

Dans une variante simple du procédé de détermination d'un seul correcteur par recherche du minimum de la puissance du bruit hors bande Nₕ, sont appliqués successivement différents correcteurs c prédéterminés sur l'enveloppe eₑᵣ. Les deux signaux d'enveloppe corrigée e'ₑᵣ et de phase Par sont multipliés. Le signal résultant d' est ensuite transposé dans le domaine fréquentiel, par transformation de Fourrier (FFT) notamment, pour le calcul de la puissance de bruit Nh. Cette puissance peut aussi être évaluée dans le domaine temporel. La comparaison de la puissance du bruit Nₕ pour les différents correcteurs prédéterminés appliqués (illustrés par des losanges sur la figure 2a, le rond illustrant le paramètre à corriger pc au départ) permet de déterminer celui des correcteurs prédéterminés pour lequel la puissance du bruit Nₕ est la plus faible.

Un autre exemple: l'évaluation du retard peut être effectué par décalage d'échantillon. Cette méthode pouvant avoir un pas de définition du retard trop grossier, il est possible d'affiner la précision à l'aide de filtres retardateurs.

La détermination du (ou des) correcteur(s) par recherche du minimum de la puissance de bruit hors bande Nh, permet une correction qui s'illustre en terme de spectre par un passage du spectre en pointillé avec des épaules élevées à un spectre en trait plein avec des épaules basses comme le monte la figure 2b. C'est pourquoi le critère de détermination du (ou des) correcteur(s) est appelé, par la suite, critère d'optimisation des épaules (nommées "shoulders" en anglais) du spectre.

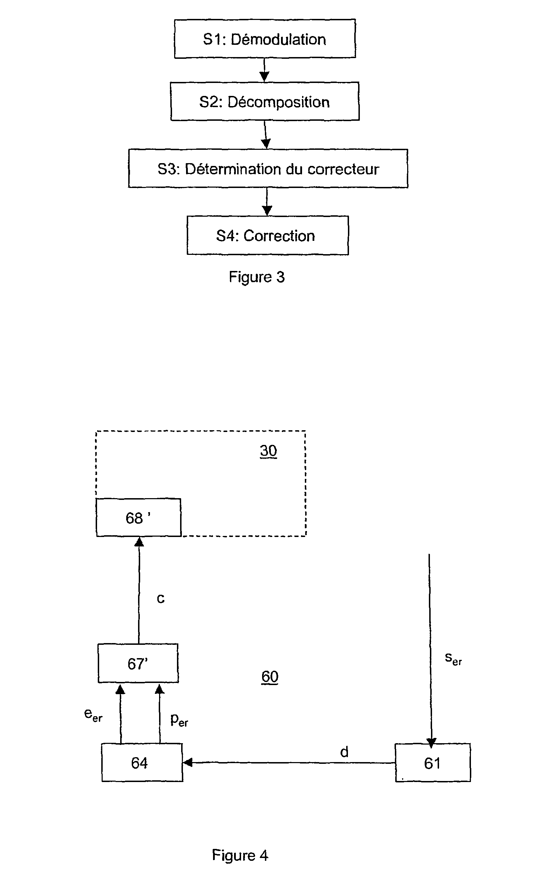

La figure 3 illustre le procédé de correction d'au moins un paramètre à corriger pc de l'enveloppe e d'un signal numérique s caractérisé en ce qu'il comporte les étapes suivantes:
- [S2] La décomposition d'un signal numérique sₑᵣ en deux signaux enveloppe eₑᵣ et phase pₑᵣ,
- [S3] La détermination du correcteur c à appliquer à chaque paramètre à corriger p_{c} de l'enveloppe eₑᵣ par recherche du minimum de puissances de bruit hors bande Nₕ.
- [S4] La correction du signal sₑᵣ par le correcteur c.

Lorsque le signal sₑᵣ est un signal modulé, le procédé comporte en outre l'étape [S1] de démodulation avant l'étape [S2] de décomposition du signal démodulé d obtenu lors de l'étape [S1] à partir du signal sₑᵣ.

L'étape [S3] de détermination de correcteur(s) c peut comporter les outils mathématiques existants de recherche du minimum d'une fonction à une ou plusieurs variables. Cette fonction dont le minimum est recherchée est celle de la puissance du bruit hors bande Nₕ, par exemple Nₕ = f₁(retard), Nh =f2(offset), Nh = f3 (retard, offset), Nh = f4(a₀, a₁...aₙ) où les paramètres [a₀, a₁...a_{n]} sont ceux d'une non-linéarité de l'enveloppe eₑᵣ, etc.

L'étape [S3] de détermination de correcteur(s) c peut ainsi comporter les sous-étapes suivantes (non illustrées sur la figure 3):
- [S31] une application successive de différentes valeurs prédéterminées {C₁ à C_{M}} du correcteur c à l'enveloppe eₑᵣ,
- [S32] une multiplication de l'enveloppe corrigée e'ₑᵣ et de la phase pₑᵣ pour chaque valeur {C₁ à C_{M}} du correcteur c,
- [S33] une transposition dans le domaine fréquentiel des signaux ainsi obtenu pour chacune des valeurs prédéterminées {C₁ à C_{M}} du correcteur c (correspondant aux losanges de la figure 2a),
- [S33] la comparaison des puissances de bruit hors bande Nₕ pour chacune des valeurs prédéterminées {C₁ à C_{M}} du correcteur c, la valeur retenue pour c étant celle correspondant à la puissance de bruit hors bande la plus faible.

La figure 4 montre un exemple de boucle de correction 60 selon l'invention. Le signal sₑᵣ dont au moins l'un des paramètres est à corriger est sur une entrée de la boucle 60.

Le procédé de correction selon l'invention est tel que le signal initial en bande de base n'est pas nécessaire. C'est pourquoi, la boucle de correction 60 peut comporter cette seule entrée recevant le signal numérique sₑᵣ ayant au moins un paramètres à corriger p_{c}.

La boucle de correction comporte un système de calcul relié directement ou indirectement à cette entrée.

Sur l'exemple de la figure 4, le signal sₑᵣ est un signal modulé. Dans ce cas, la boucle de correction 60 comporte un démodulateur 61 recevant ce signal sₑᵣ et fournissant le signal démodulé d correspondant. Le signal ainsi démodulé d est présenté au système de calcul.

Lorsque le signal sₑᵣ est un signal en bande de base, celui-ci est directement présenté au système de calcul. La boucle de correction 60 ne comporte alors pas de démodulateur 61.

Le système de calcul comporte des moyens de décomposition 64 du signal qui lui est présenté sₑᵣ ou d (suivant, respectivement, que sₑᵣ est en bande de base ou modulé) en deux signaux enveloppe eₑᵣ et phase pₑᵣ.

Le système de calcul comporte en outre des moyens de détermination du correcteur c 67' à appliquer à chaque paramètre à corriger pc. les moyens de détermination du correcteur c 67' reçoivent l'enveloppe eₑᵣ et la phase pₑᵣ des moyens de décomposition 64. Le critère appliqué par ces moyens de détermination 67' est celui d'optimisation des épaules du spectre. Pour cela, les moyens de détermination 67' mettent en oeuvre les outils mathématiques existant de recherche de minimum d'une fonction, en l'occurrence de la puissance de bruit hors bande Nₕ.

Les paramètres à corriger p_{c} sont un retard et/ou un offset du signal d'enveloppe eₑᵣ par rapport au signal de phase Par du signal numérique, et/ou une non-linéarité du signal d'enveloppe eₑᵣ, et les correcteurs c sont, respectivement, un retard inverse et/ou un offset inverse et/ou une pré-correction.

Les moyens de détermination 67' du système de calcul fournisse à un dispositif de correction 68' le (ou les) correcteurs) c qu'il a déterminé. Le dispositif de correction 68' est destiné à être implémenté dans une chaîne de traitement du signal numérique. Dans l'exemple de la figure 4, le dispositif de correction 68' est destiné à être implémenté dans un modulateur 30 auquel le démodulateur 61 est associé.

Une telle boucle de correction peut être implémentée dans différents type d'émetteur, par exemple des émetteurs utilisant la méthode de Kahn, des émetteur linéaires, etc. Elle est notamment intéressante pour tout type d'émetteur AM conventionnel utilisant la méthode de modulation Kahn.

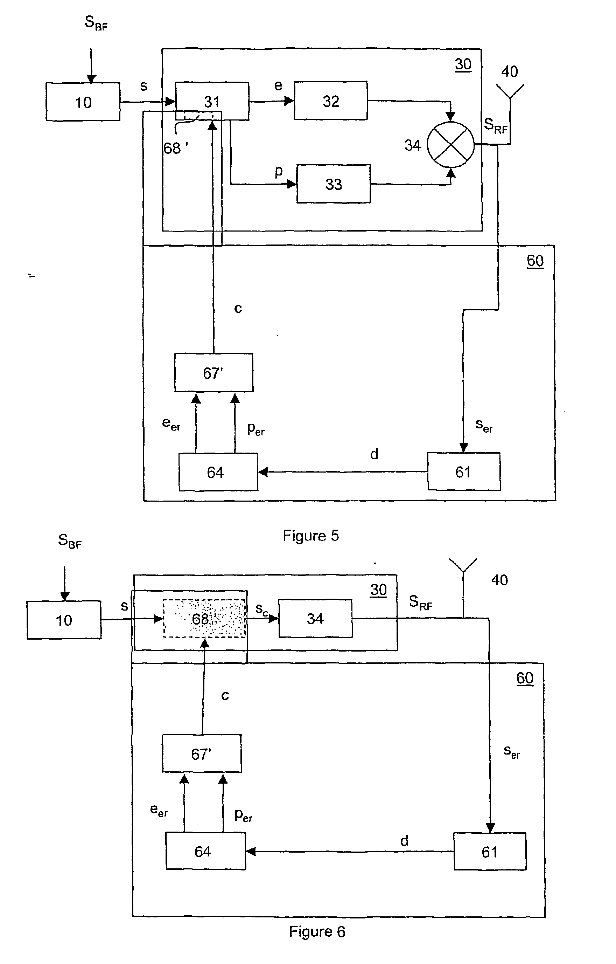

La boucle de correction 60 permet ainsi un rattrapage automatique et le réglage dynamique de paramètre, notamment du retard entre l'enveloppe eₑᵣ et la phase pₑᵣ. Ils sont assurés par un démodulateur 61, par exemple un démodulateur RF comme l'illustre les figures 5 et 6, et un dispositif de correction 68', notamment un logiciel de pré-correction dynamique, implémenté dans le modulateur 30, en particulier dans le calculateur 31 de ce modulateur.

La figure 5 illustre un émetteur utilisant la méthode de Kahn comportant une boucle de correction selon l'invention. La boucle de correction 60 assure alors un réglage dynamique avec rattrapage automatique et permet une émission hors bande de qualité quelle que soit la fréquence ou le mode de transmission sélectionné.

Le dispositif de traitement du signal 10 reçoit le signal basse fréquence S_{BF} et fournit le signal en bande de base s correspondant. Le signal s numérique en bande de base est un signal complexe.

La plupart des émetteurs de radiodiffusion les plus efficaces utilisent la méthode de modulation de Kahn qui implique de traiter séparément l'enveloppe e et la phase p (32, 33) et de recombiner (34) ces deux signaux e et p à la sortie.

Le modulateur 30 utilisant la méthode de Kahn est illustré par la figure 5. Le signal s en bande de base est traité par le dispositif de calcul 31 qui sépare ce signal en un signal d'enveloppe e et un signal de phase p. Les dispositifs de traitements 32 et 33 opèrent ensuite sur, respectivement, ce signal d'enveloppe e et ce signal de phase p. Le multiplicateur 34 recombine ensuite ces deux signaux d'enveloppe e et de phase p en un signal S_{RF}. Le signal S_{RF} est émis via l'antenne 40.

Comme l'enveloppe e et la phase p sont traitées par deux chemins différents et indépendants, respectivement, 32 et 33, différents paramètres entre ces deux chemins, notamment le retard, doivent être ajustés précisément afin d'obtenir un signal RF S_{RF} de haute qualité avec un niveau acceptable de la puissance de bruit hors bande Nₕ.

Considérons le paramètres à ajuster comme étant le retard. Prenant en considération que le temps de traitement n'est pas constant et peut varier, notamment en fonction du mode opératoire et de la fréquence, et prenant en considération la haute sensibilité de cet ajustement sur la qualité finale du signal RF numérique émis, une boucle de correction 60 selon l'invention est implémenté dans cet émetteur. Cette boucle de correction 60 permet le rattrapage automatique et le réglage dynamique du retard.

Après un éventuel préréglage manuel pendant la phase de mise en service de l'émetteur, cette option constitué par la boucle de correction 60 selon l'invention est capable d'exécuter le rattrapage automatique et le réglage dynamique du retard pour parer aux variations possible de temps de retard dues aux changements de conditions d'utilisation (mode, fréquence, etc.).

Pour exécuter ce rattrapage automatique et de réglage dynamique du retard r, un échantillon RF sₑᵣ pris à la sortie de l'émetteur est démodulé 61 et traité 64, 67'. Une pré-correction numérique 68' est appliqué directement sur le signal s en bande de base afin d'avoir un résultat optimisé à la sortie de l'émetteur. Le traitement numérique peut être effectué de manière itérative pour obtenir le meilleur résultat possible.

La boucle de correction 60 implémenté dans l'émetteur utilisant la méthode de modulation de Kahn dont un exemple est proposé par la figure 5 a son entrée relié à la sortie de l'émetteur pour recevoir l'échantillon RF sₑᵣ du signal émis S_{RF}. Son démodulateur 61 s fournit le signal démodulé d aux moyens de décomposition 64 en signaux enveloppe eₑᵣ et phase pₑᵣ. Ses moyens de détermination 67' du correcteur c du retard r traitent l'enveloppe eₑᵣ et phase pₑᵣ en recherchant le minimum de la puissance de bruit hors bande Nₕ, et transmettent le correcteur c au dispositif de correction 68' implémenté dans le dispositif de calcul 31 du modulateur 30 afin qu'il opère la correction.

Ces moyens de détermination 67' et ce dispositif de correction 68' sont aussi capable de déterminer le (ou les) correcteurs) de l'offset du signal d'enveloppe eₑᵣ par rapport au signal de phase pₑᵣ et une non-linéarité du signal d'enveloppe pₑᵣ. La détermination et la correction de chacun de ces paramètres: retard, offset, non-linéarité peuvent être effectuées séparément ou en combinaison.

La figure 6 illustre un émetteur linéaire (Classe A ou B) comportant une boucle de correction selon l'invention. Le dispositif de traitement du signal 10 reçoit le signal basse fréquence S_{BF} et fournit le signal en bande de base s correspondant. Le signal s numérique en bande de base est un signal complexe.

Le modulateur 30 d'un émetteur linéaire est illustré par la figure 5. Le signal s en bande de base est transposé en radio fréquence : signal S_{RF} le dispositif 35. Le signal S_{RF} est émis via l'antenne 40.

Considérons les paramètres à ajuster comme étant les paramètres d'une non-linéarité de l'enveloppe e. La boucle de correction 60 permet le rattrapage automatique et le réglage dynamique de cette non-linéarité .

Pour exécuter ce rattrapage automatique et de réglage dynamique de cette non-linéarité, un échantillon RF sₑᵣ pris à la sortie de l'émetteur est démodulé 61 et traité 64, 67'. Une pré-correction numérique 68' est appliqué directement sur le signal s en bande de base afin d'avoir un résultat optimisé à la sortie de l'émetteur. Le traitement numérique peut être effectué de manière itérative pour obtenir le meilleur résultat possible.

La boucle de correction 60 implémenté dans l'émetteur linéaire dont un exemple est proposé par la figure 6 a son entrée relié à la sortie de l'émetteur pour recevoir l'échantillon RF sₑᵣ du signal émis S_{RF}. Son démodulateur 61 s fournit le signal démodulé d aux moyens de décomposition 64 en signaux enveloppe eₑᵣ et phase pₑᵣ. Ses moyens de détermination 67' du correcteur c de la non-linéarité traitent l'enveloppe eₑᵣ et phase pₑᵣ en recherchant le minimum de la puissance de bruit hors bande Nₕ, et transmettent le correcteur c au dispositif de correction 68' implémenté dans le dispositif de calcul 31 du modulateur 30 afin qu'il opère la correction.

Ces moyens de détermination 67' et ce dispositif de correction 68' sont aussi capable de déterminer le (ou les) correcteur(s) du retard et/ou de l'offset du signal d'enveloppe eₑᵣ par rapport au signal de phase pₑᵣ. La détermination et la correction de chacun de ces paramètres: retard, offset, non-linéarité peuvent être effectuées séparément ou en combinaison.

Les émetteurs, notamment ceux utilisant la modulation de Kahn et les émetteurs linéaires, comportant une telle boucle de correction 60 émetteur peuvent être utilisés pour la radiodiffusion ou télédiffusion de signaux numériques.

La boucle de correction 60 selon l'invention peut être plus généralement utilisée dans toutes applications un signal numérique complexe comportant un ou plusieurs paramètre à corriger. Particulièrement, cette boucle de correction 60 est bien adapté lorsque l'on ne dispose pas du signal initial comme élément de comparaison.

## Revendications

1. Procédé de correction d'au moins un paramètre à corriger (pc) d'un signal numérique complexe (sₑᵣ, d) comportant les étapes suivantes:
- La décomposition du signal en deux signaux enveloppe (eₑᵣ) et phase (pₑᵣ),
- La détermination du correcteur (c) à appliquer au paramètre de l'enveloppe, ledit correcteur étant obtenu par recherche, parmi des valeurs prédéterminées, de la valeur du correcteur correspondant au minimum de la puissance de bruit hors bande du signal de sortie d'une chaîne de traitement de signal numérique comportant une correction en fonction dudit correcteur.

2. Boucle de correction d'au moins un paramètre à corriger (pc) d'un signal numérique complexe (sₑᵣ, d) comportant:
- Une entrée sur laquelle elle reçoit le signal numérique (sₑᵣ, d),
- Un système de calcul relié directement ou indirectement à cette entrée,
- Un dispositif de correction (68') implémenté dans une chaîne de traitement du signal numérique, et relié au système de calcul qui lui fournit au moins un correcteur (c),
**caractérisé en ce que** le système de calcul est configuré de telle sorte qu'il comporte:
- Des moyens de décomposition (64) du signal en deux signaux enveloppe (eₑᵣ) et phase (pₑᵣ), et
- Des moyens de détermination (67') du correcteur (c) à appliquer à chaque paramètre à corriger (p_{c}) de l'enveloppe par recherche, parmi des valeurs prédéterminées, de la valeur du correcteur correspondant au minimum de puissance de bruit hors bande du signal de sortie d'une chaîne de traitement de signal numérique comportant une correction en fonction dudit correcteur.

3. Boucle de correction selon la revendication précédente **caractérisée en ce que** l'entrée est la seule entrée.

4. Boucle de correction selon l'une des revendications 2 ou 3 **caractérisé en ce que** les paramètres à corriger (p_{c}) comportent un retard et les correcteurs (c) comportent un retard inverse:

5. Boucle de correction selon l'une des revendications 2 à 4 **caractérisé en ce que** les paramètres à corriger (p_{c}) comportent un offset du signal d'enveloppe par rapport au signal de phase du signal numérique.et les correcteurs (c) comportent un offset inverse.

6. Boucle de correction selon l'une des revendications 2 à 5 **caractérisé en ce que** les paramètres à corriger (p_{c}) comportent une non-tinéarité du signal d'enveloppe, et les correcteurs (c) comportent une pré-correction.

7. Boucle de correction selon l'une quelconque des revendications 2 à 6 **caractérisé en ce que** le signal numérique est un signal numérique modulé (S_{RF}) et **en ce que** la boude comporte:
- Un démodulateur (61) entre l'entrée et le système de calcul,
- Un dispositif de correction (68') destiné à être implémenté dans un modulateur (30) auquel le démodulateur (61) est associé.

8. Emetteur comportant un modulateur (30) et la boucle de correction (60) selon la revendication précédente.

9. Emetteur selon la revendication précédente **caractérisé en ce qu'**il s'agit d'un émetteur linéaire.

10. Emetteur selon la revendication 8 **caractérisé en ce qu'**il comporte des moyens de traitement (32,33) séparés de la phase et de l'enveloppe du signal numérique modulé.

11. Emetteur selon la revendication précédente **caractérisé que** le modulateur (30) comporte des moyens de traitement séparés de l'enveloppe et de la phase et un multiplicateur du signal d'enveloppe et du signal'de phase en sortie mettant en oeuvre la méthode de Kahn.

12. Utilisation de l'émetteur selon l'une quelconque des revendications 8 à 11 pour la radiodiffusion ou télédiffusion de signaux numériques.

## Claims

1. Method of correcting at least one parameter to be corrected (pc) of a complex digital signal (sₑᵣ, d) comprising the following steps:
- the decomposition of the signal into two signals, envelope (eₑᵣ) and phase (pₑᵣ).
- the determination of the corrector (c) to be applied to the parameter of the envelope, said corrector being obtained by searching, among predetermined values, for the value of the corrector corresponding to the minimum of the out-of-band noise power of the output signal of a digital signal processing chain comprising a correction as a function of said corrector.

2. Loop for correcting at least one parameter to be corrected (pc) of a complex digital signal (sₑᵣ, d) comprising:
- an input on which it receives the digital signal (sₑᵣ, d),
- a calculation system linked directly or indirectly to this input,
- a correction device (68') deployed in a chain for processing the digital signal, and linked to the calculation system which provides it with at least one corrector (c),
**characterized in that** the calculation system is configured in such a way that it comprises:
- means of decomposition (64) of the signal into two signals, envelope (eₑᵣ) and phase (pₑᵣ), and
- means of determining (67') the corrector (c) to be applied to each parameter to be corrected (p_{c}) of the envelope by searching, among predetermined values, for the value of the corrector corresponding to the minimum out-of-band noise power of the output signal of a digital signal processing chain comprising a correction as a function of said corrector.

3. Correction loop according to the preceding claim **characterized in that** the input is the only input.

4. Correction loop according to one of Claims 2 or 3 **characterized in that** the parameters to be corrected (p_{c}) comprise a delay and the correctors (c) comprise an inverse delay.

5. Correction loop according to one of Claims 2 to 4 **characterized in that** the parameters to be corrected (p_{c}) comprise an offset of the envelope signal with respect to the phase signal of the digital signal and the correctors (c) comprise an inverse offset.

6. Correction loop according to one of Claims 2 to 5 **characterized in that** the parameters to be corrected (p_{c}) comprise a nonlinearity of the envelope signal, and the correctors (c) comprise a precorrection.

7. Correction loop according to any one of Claims 2 to 6 **characterized in that** the digital signal is a modulated digital signal (S_{RF}) and **in that** the loop comprises:
- a demodulator (61) between the input and the calculation system,
- a correction device (68') intended to be deployed in a modulator (30) with which the demodulator (61) is associated.

8. Transmitter comprising a modulator (30) and the correction loop (60) according to the preceding claim.

9. Transmitter according to the preceding claim **characterized in that** it is a linear transmitter.

10. Transmitter according to Claim 8 **characterized in that** it comprises separate means of processing (32, 33) of the phase and of the envelope of the modulated digital signal.

11. Transmitter according to the preceding claim **characterized in that** the modulator (30) comprises separate means of processing of the envelope and of the phase and a multiplier of the envelope signal and of the phase signal at the output implementing the method of Kahn.

12. Use of the transmitter according to any one of Claims 8 to 11 for the radio broadcasting or telebroadcasting of digital signals.

## Patentansprüche

1. Verfahren zur Korrektur mindestens eines zu korrigierenden Parameters (p_{c}) eines komplexen digitalen Signals (sₑᵣ, d), das die folgenden Schritte aufweist:
- die Zerlegung des Signals in zwei Signale, ein Hüllkurvensignal (eₑᵣ) und ein Phasensignal (pₑᵣ),
- die Bestimmung des an den Parameter der Hüllkurve anzulegenden Korrekturwerts (c), wobei der Korrekturwert durch Suche unter vorbestimmten Werten nach demjenigen Korrekturwert erhalten wird, der dem Minimum der Rauschleistung außerhalb der Bandbreite des Ausgangssignals einer Verarbeitungskette eines digitalen Signals entspricht, die eine Korrektur in Abhängigkeit vom Korrekturwert aufweist.

2. Korrekturschleife mindestens eines zu korrigierenden Parameters (p_{c}) eines komplexen digitalen Signals (sₑᵣ, d), die aufweist:
- einen Eingang, an dem sie das digitale Signal (sₑᵣ, d) empfängt,
- ein Rechensystem, das direkt oder indirekt mit diesem Eingang verbunden ist,
- eine Korrekturvorrichtung (68'), die in eine Verarbeitungskette des digitalen Signals implementiert und mit dem Rechensystem verbunden ist, das ihr mindestens einen Korrekturwert (c) liefert,
**dadurch gekennzeichnet, dass** das Rechensystem so konfiguriert ist, dass es aufweist:
- Mittel (64) zum Zerlegen des Signals in zwei Signale, ein Hüllkurvensignal (eₑᵣ) und ein Phasensignal (pₑᵣ) , und
- Mittel (67') zur Bestimmung des Korrekturwerts (c), der an jeden zu korrigierenden Parameter (p_{c}) des Hüllkurvensignals anzulegen ist, durch Suche unter vorbestimmten Werten nach demjenigen Korrekturwert, der dem Minimum der Rauschleistung außerhalb der Bandbreite des Ausgangssignals einer Verarbeitungskette eines digitalen Signals entspricht, die eine Korrektur in Abhängigkeit vom Korrekturwert aufweist.

3. Korrekturschleife nach dem vorhergehenden Anspruch, **dadurch gekennzeichnet, dass** der Eingang der einzige Eingang ist.

4. Korrekturschleife nach einem der Ansprüche 2 oder 3, **dadurch gekennzeichnet, dass** die zu korrigierenden Parameter (p_{c}) eine Verzögerung und die Korrekturwerte (c) eine umgekehrte Verzögerung aufweisen.

5. Korrekturschleife nach einem der Ansprüche 2 bis 4, **dadurch gekennzeichnet, dass** die zu korrigierenden Parameter (p_{c}) ein Offset des Hüllkurvensignals bezüglich des Phasensignals des digitalen Signals und die Korrekturwerte (c) ein umgekehrtes Offset aufweisen.

6. Korrekturschleife nach einem der Ansprüche 2 bis 5, **dadurch gekennzeichnet, dass** die zu korrigierenden Parameter (p_{c}) eine Nicht-Linearität des Hüllkurvensignals und die Korrekturwerte (c) eine Vorkorrektur aufweisen.

7. Korrekturschleife nach einem der Ansprüche 2 bis 6, **dadurch gekennzeichnet, dass** das digitale Signal ein moduliertes digitales Signal (S_{RF}) ist, und dass die Schleife aufweist:
- einen Demodulator (61) zwischen dem Eingang und dem Rechensystem,
- eine Korrekturvorrichtung (68'), die dazu bestimmt ist, in einem Modulator (30) implementiert zu werden, dem der Demodulator (61) zugeordnet ist.

8. Sender, der einen Modulator (30) und die Korrekturschleife (60) nach dem vorhergehenden Anspruch aufweist.

9. Sender nach dem vorhergehenden Anspruch, **dadurch gekennzeichnet, dass** es ein linearer Sender ist.

10. Sender nach Anspruch 8, **dadurch gekennzeichnet, dass** er getrennte Verarbeitungsmittel (32, 33) der Phase und der Hüllkurve des modulierten digitalen Signals aufweist.

11. Sender nach dem vorhergehenden Anspruch, **dadurch gekennzeichnet, dass** der Modulator (30) getrennte Verarbeitungsmittel der Hüllkurve und der Phase und einen Multiplikator des Hüllkurvensignals und des Phasensignals am Ausgang aufweist, der die Kahn-Methode verwendet.

12. Verwendung des Senders nach einem der Ansprüche 8 bis 11 für die Funk- oder Fernsehsendung von digitalen Signalen.
